(19) **Europäisches Patentamt**

**European Patent Office**

**Office européen des brevets**

(11) **EP 0 610 495 B1**

(12) **EUROPEAN PATENT SPECIFICATION**

(45) Date of publication and mention
of the grant of the patent:
**19.04.2000 Bulletin 2000/16**

(51) Int. Cl.⁷: **H03J 1/00**

(21) Application number: **93921249.4**

(86) International application number:
**PCT/US93/08150**

(22) Date of filing: **30.08.1993**

(87) International publication number:
**WO 94/06208 (17.03.1994 Gazette 1994/07)**

(54) **TELEVISION TUNING APPARATUS**

Abstimmschaltung für Fernsehempfänger

APPAREIL D'ACCORD POUR TELEVISION

(84) Designated Contracting States:
**DE FR GB IT**

(30) Priority: **28.08.1992 GB 9218373**

(43) Date of publication of application:
**17.08.1994 Bulletin 1994/33**

(73) Proprietor:
**THOMSON CONSUMER ELECTRONICS, INC.**
**Indianapolis Indiana 46201 (US)**

(72) Inventor: **BADGER, David, Mark**
**Indianapolis, IN 46254 (US)**

(74) Representative:
**Wördemann, Hermes, Dipl.-Ing.**
**Deutsche Thomson-Brandt GmbH**
**Licensing & Intellectual Property**
**Postfach 61 01 31**
**30601 Hannover (DE)**

(56) References cited:
**EP-A- 0 298 625**          **US-A- 4 334 323**

• **PATENT ABSTRACTS OF JAPAN vol. 10, no. 39
(E-381)(2096) 15 February 1986 & JP,A,60 194
818 (ONKYO K.K.) 3 October 1985**

**Description**

The present invention pertains to the frequency alignment of a plurality of tunable filters of a tuner which have a tuning frequency responses which are determined by the magnitudes of respective control signals.

BACKGROUND

US patent 4, 334,323 describes a tuning system, comprising a plurality of tunable circuits for coupling an RF signal source to a frequency conversion means, each of the tunable circuits including a reactive element having a reactive value determined by the magnitude of a respective analog control signal; a phase lock loop coupled to supply a tuning signal to a local oscillator for providing a frequency conversion signal to the frequency conversion means; control means responsive to a channel selection signal source for providing a plurality of digital channel selection signals; and circuit means for applying the plurality of digital channel selection signals to the tunable circuits for tuning channels selected by the channel selection signal.

Tunable filters responsive to the magnitude of a control signal, e.g., a tuning voltage, are employed to select one RF carrier from a plurality of received RF carriers, and for generating a local oscillator (LO) signal having the appropriate frequency for heterodyning the selected RF carrier to produce the IF signal. When the passband of the RF filters do not properly track with each other and the frequency of the local oscillator signal, the desired resultant IF signal may be degraded and the possibility of crosstalk from adjacent TV channels is increased.

Tunable filters usually include a voltage controlled capacitance (varactor) diode as a frequency control element because a varactor diode exhibits a capacitance vs. voltage characteristic when they are reverse biased.

Owing to the normal tolerances of components employed in tuning systems and to normal production variations, it is necessary that the tunable filters in the RF tuner be initially adjusted in production. This is because the varactor diodes in the RF filters and local oscillator circuits do not have precisely the same capacitance characteristics over the voltage range corresponding to the tuning band of frequencies. This initial adjustment typically involves mechanically "trimming" inductive and capacitive elements so that the frequency responses of the various tuned circuits are aligned and track one another throughout one or more frequency bands. However, these alignment adjustments are often time-consuming, sometimes requiring an iterative alignment procedure.

Summary of the invention

The present invention which is defined by claim 1 has application to tuning systems (10) of a type including input means (12) for receiving a plurality of RF signals corresponding to respective channels; frequency selection means (14,18) for selecting one of the plurality of RF signals corresponding to a respective selected channel, conversion means (24) for producing at an output an information bearing signal (IF) in accordance with the modulation of a selected RF signal, apparatus comprising: a plurality of tunable circuits (14,20,22) coupled between the input means and the output and cooperating to control the frequency characteristics of the tuning system (10) between the input means and the output; each of the tunable circuits including a reactive element (capacitor or varactor) having a reactive value determined by the magnitude of a respective analog control signal (VC32,VC34,VC36); means (40) for providing a plurality of digital channel selection signals in response to a selected channel; means (28) comprising a phase lock loop for generating a tuning voltage having a magnitude responsive to the selected channel; circuit means (32,34,36) comprising means for combining said tuning voltage (Vtd) of the phase lock loop (28) with the digital channel selection signals to provide said analog control signals for application to the plurality of tunable circuits (14,20,18) and means for coupling said analog control signals (VC32,VC34,VC36) to respective ones of said tunable circuits.

In accordance with the invention, the tuning system is characterized in that the circuit means further includes means (50, 52, 54) for scaling said tuning voltage (Vto) in response to said digital channel selection signal to produce said analog control signals (VC32, VC34, VC36) with the value of scaling being determined by said digital channel selection signal.

BRIEF DESCRIPTION OF THE DRAWINGS

Figure 1 is a block diagram of a tuner of a television system which may utilize an arrangement constructed according to aspects of the present invention.

Figure 2 is a schematic of an arrangement constructed according to the present invention which may be employed in the television system shown in Figure 1.

Figure 3 is an block diagram representation of the arrangement shown in Figure 2.

Figure 4 is a schematic diagram of a modification of the arrangement shown in Figure 2 including a temperature compensation circuit.

DETAILED DESCRIPTION OF THE PREFERRED EMBODIMENT

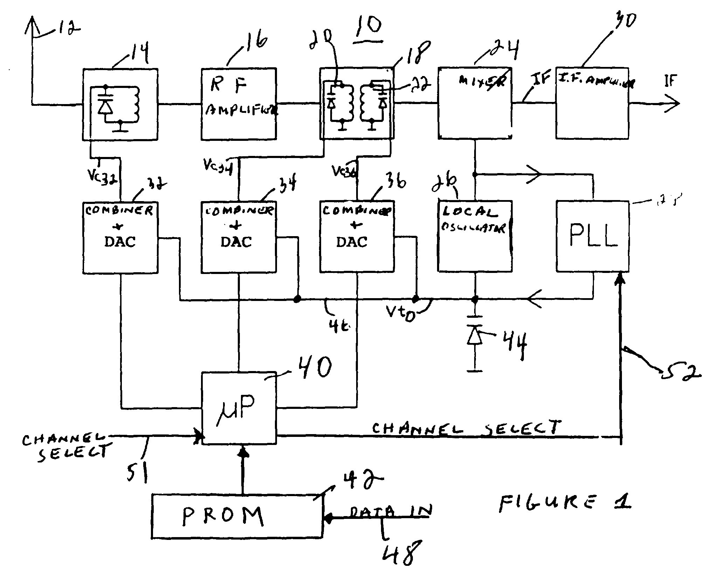

Figure 1, shows a tuner section 10 of a television apparatus and includes an input 12 for receiving television RF carriers provided by an antenna, cable system, or other input device, such as a VCR. The received RF signals are filtered by an input RE filter 14 to attenuate undesired signals. The output signals of filter 14 are amplified by RF amplifier 16. The output signals of amplifier 16 are coupled to a double tuned RF output filter 18 which includes two tunable circuits 20 and 22. The RF signals from circuit 22 are coupled to mixer 24 and are heterodyned with the output signal of a local oscillator 26 which has its frequency controlled by phase locked loop (PLL) 28 in response to a tuning voltage Vto. The output of mixer 24 is an IF signal which is amplified and filtered by IF amplifier 30.

Tunable filters 14, 20, 22 each include a tuned circuit comprising an inductor and a varactor diode connected in parallel combination. The varactor diodes of tuning filters 14, 20 and 22 receive respective tuning voltages Vc32, Vc34 and Vc36.

Tuning voltages Vc32, Vc34 and Vc36 for tuned circuits 14, 20, and 22 are generated by a respective DAC and combiner units 32, 34, and 36 in response to digital signals fed from microprocessor (uP) 40 and the tuning voltage Vto of PLL 28. When a channel is selected, microprocessor 40 generates digital trimming or adjustment control signals which are determined from data stored in PROM 42 and which are coupled to addressable DAC's 32, 34, and 36. Microprocessor controller 40 also provides the appropriate division factor (usually referred to as "N") in digital form to PLL 28. In response to the digital division factor, N, PLL 28 generates an analog tuning voltage Vto to adjust the frequency of local oscillator 26 by changing the capacitance of a varactor diode 44 associated with local oscillator 26. Tuning voltage Vto is also coupled via line 46 to DAC and combining units 32, 34, and 36.

In production at the factory, the optimum trimming voltages provided by respective DACs of units 32, 34, and 36 for tuning the varactor diodes of tuning circuits 14, 20, 22 are determined. The tuning voltages Vc32, Vc34 and Vc36 for tunable circuits 14, 20 and 22 respectively are a combination of the analog voltage corresponding to the digital trimming controls signal received from PROM 42 via microprocessor 40 and tuning voltage Vto received on line 46 from PLL 28, as will be discussed more fully below.

During production, the digital trimming control signals to be provided by microprocessor 40 for optimal tuning of tuning circuits 14, 20, and 22 are received via bus line 48 and written into PROM 42. At a later time, when a viewer enters a channel select signal via bus line 51, a digital channel select signal is passed to PLL 28 via line 52 and the digital trimming control data is read from PROM 42.

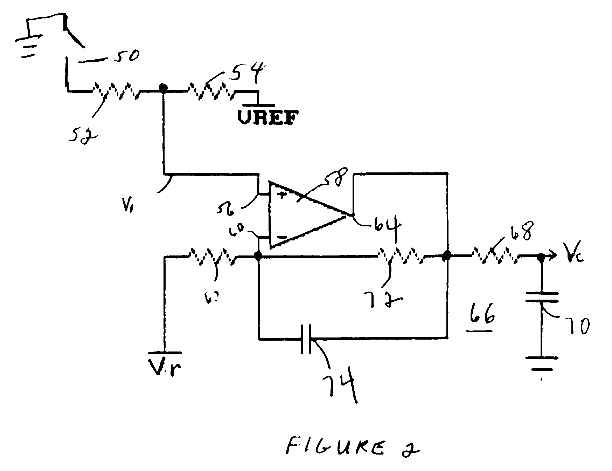

Referring now to Figure 2, there is shown the DAC and combining circuitry within each of units 32, 34, and 36 shown in block form in Figure 1. The output signal of microprocessor 40 corresponding to the digital trimming data stored in PROM 42 is a pulse width modulated (PWM) pulse signal. The PWM signal controls electronic switch 50. Switch 50 is coupled between one end of a voltage divider comprising resistors 52 and 54 and signal ground. The other end of the voltage divider receives a reference voltage Vref. Reference voltage Vref is the combination of a divided down version of PLL tuning voltage Vto and a constant voltage Vo according to the equation Vref=kVto+Vo (see Figure 3). A voltage V1 developed at the junction of resistors 54 and 52 is fed to non-inverting input 56 of operational amplifier (op amp) 58. A voltage Vr is fed to inverting input 60 through resistor 62. Voltage Vr provides an adjustable "offset" voltage for centering the output tuning voltage Vc within the adjustment tuning range for the particular band of frequencies which are being tuned. Output terminal 64 is coupled to output filter 66 comprising resistor 68 and capacitor 70, with feedback being provided from terminal 64 to terminal 60 by resistor 72 and capacitor 74.

A block diagram version of the circuit shown in Figure 2 is shown in Figure 3, wherein like members have like designations. Figure 3 shows the combination of a version of voltage Vto (amplified by a factor Ko) and constant voltage Vo to form Vref. Voltage V1 is combined with a version of voltage Vr amplified by a factor G to produce an output signal at line 64. The later signal is lowpass filtered by low pass filter 66 to produce tuning voltage Vc.

Mathematically, the control voltage can be expressed as:

$$Vc = (KoVto+Vo)(1-K2Kdac)(G+1)-GVr$$

if $GKo=1$, $Vr=Vo$, and $K2(G+1)=2$, the above equation simplifies to:

$$Vc=Vto+KoVto+Vo-2Kdac(KoVto+Vo).$$

If $Ko=0.16$ and $Vo=1$, then $\pm1$ volt for $Vc=0$, and $\pm 5$ volts for $Vc=25$.

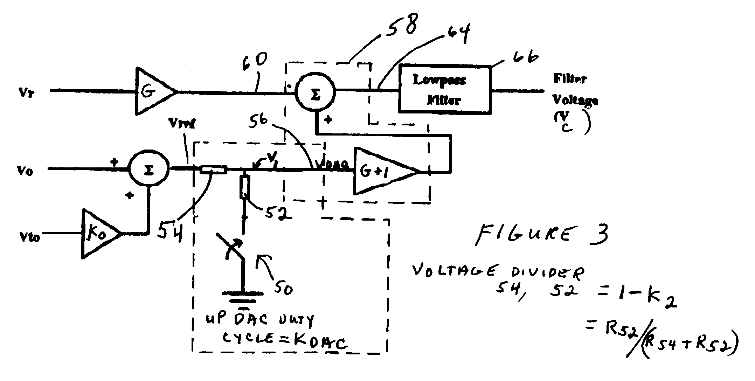

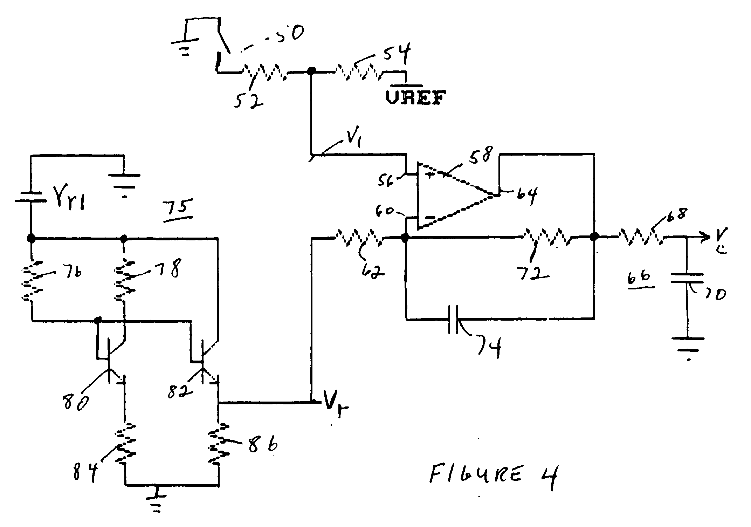

Figure 4 shows a temperature compensation circuit 75 for temperature compensating the circuit of Figure 2. Temperature compensation circuit 75 is substituted for the source of "offset" voltage Vr of the arrangement shown in Figure 2. The bases of each of transistors 80, 82 are coupled to a source of voltage Vr1 through resistor 76, with the collector of transistor 80 being coupled to Vr1 through resistor 78 and the collector of transistor 82 being coupled directly to source of voltage Vr1. The emitters of transistors 80 and 82 are respectively coupled to ground through resistors 84 and 86 with output voltage Vr being taken across resistor 86. A temperature compensated version of Vr is provided by transistor 82. The base-to-emitter voltage change of transistor 82 with changes of temperature are tracked by the base-emitter voltage change of transistor 80.

The application of Vto from the PLL reduces the number of channels requiring alignment and therefore the total amount of data requiring storage in the PROM. If the tuning voltage (Vc) for the tunable filters 14, 20, and 22 were responsive only to the DACs, not only would the DACs need to be high resolution DACs, but each channel would require alignment data. However, with the tuning voltage Vc being responsive to Vto, the tuning voltage Vc will change with channel even for the same DAC output. This first approximation provided by the application of Vto is sufficient for alignment over a small range of channels, thus reducing the number of channels requiring unique data. Both the reduced range of the DAC and the fewer number of channels requiring unique alignment data means that much less data needs to be stored in the PROM with a subsequent savings of cost of the PROM.

The voltage divider of resistors 52, 54 maintains the first approximation offered by the application of Vto. If the divider were not present (resistor 52 being replaced by a short circuit wire), the voltage V1 at 56, and consequently the tuning voltage Vc, would be zero for a DAC setting of zero. Thus, for channels requiring a large Vto, the adjustment range of Vc afforded by the DAC would also be large (zero volts to more than Vto) and the DAC resolution would have to be larger. The inclusion of the resistive voltage divider 52, 54 prevents the tuning voltage Vc from reaching below a predetermined minimum when the DAC output voltage is zero volts and Vto is large.

With the proper selection of component values, the application of Vto, as represented by Vref combined with the resistive voltage divider 52, 54, work to provide a tuning voltage Vc substantially equal to Vto when the DAC is set to the mid-range tuning for a particular channel. As the DAC setting is increased or decreased from mid-range, the tuning voltage Vc is offset from Vto. Further, the offset tuning range provided by the DAC is proportional to Vto providing a greater tuning range at high channels where the varactor sensitivity is less and a lower tuning range at low channels where greater voltage resolution is needed.

## Claims

1. An apparatus in a tuning system (1) said tuning system including

  input means (12) for receiving a plurality of RF signals corresponding to respective channels; frequency selection means (14, 18) for selecting one of said plurality of RF signals corresponding to a respective selected channel; conversion means (24) for producing at an output an information bearing signal in accordance with the modulation of a selected RF signal, said apparatus comprising:

a plurality of tunable circuits (14, 20, 22) coupled between said input means and said output and cooperating to control the frequency characteristics of said tuning system (10) between said input and said output;

each of said tunable circuits including a reactive element having a reactive value determined by the magnitude of respective analog control signals (VC32, VC34, VC36);

means (40) for providing a plurality of digital channel selection signals in response to a selected channel;

means (28) comprising a phase locked loop for generating a tuning voltage (Vto) having magnitude responsive to said selected channel;

circuit means (32, 34, 36) comprising means for combining said tuning voltage (Vto) of said phase looked loop (28) with said digital channel selection signals to produce said analog control signals (VC32, VC34, VC36) for application to said plurality of tunable circuits (14, 20, 22);

means for coupling said analog control signals (VC32, VC34, VC36) to respective ones of said tunable circuits, and characterized in that: said circuit means (32, 34, 36) further includes means (50, 52, 54) for scaling said tuning voltage (Vto) in response to said digital channel selection signal to produce said analog control signals (VC32, VC34, VC36) with the value of scaling being determined by said digital channel selection signal.

## Patentansprüche

1. Vorrichtung in einem Abstimmsystem (10), wobei das Abstimmsystem umfasst:

  Eingabemittel (12) zum Empfang einer Vielzahl von verschiedenen Kanälen entsprechenden HF-Signalen;

  Frequenzauswählmittel (14, 18 ) zur Auswahl eines der HF-Signale das einem jeweils ausgewählten Kanal entspricht,

  Übersetzungsmittel (24) zur Erzeugung eines Informationen enthaltenen Signals an einem Ausgang in Übereinstimmung mit der Modulation eines ausgewählten HF-Signals, wobei die Vorrichtung umfasst:

  eine Vielzahl von abstimmbaren Schaltkreisen (14, 20, 22) die zwischen den Eingabemitteln und dem Ausgang angeschlossen sind und zusammenwirken um die Frequenzcharakteristiken des Abstimmsystems (10) zwischen dem Eingang und dem Ausgang zu steuern;

wobei jedes der abstimmbaren Schaltkreise ein Blindelement enthält mit einem durch die Amplitude derjeweiligen analogen Steuersignale (VC32, VC34, VC36) bestimmbaren Blindwert;

Mittel (40) zur Bereitstellung einer Vielzahl von digitalen Kanalauswahlsignalen als Reaktion aufeinen ausgewählten Kanal;

Mittel (28) umfassend einen Phasenregelkreis (PLL) zur Erzeugung einer Abstimmspannung (Vto) mit einer aufden ausgewählten Kanal reagierenden Amplitude;

Schaltkreismittel (32, 34, 36) umfassend Mittel zur Verknüpfung der Abstimmspannung (Vto) des Phasenregelkreises (28) mit den digitalen Kanalauswahlsignalen um die analogen Steuersignale (VC32, VC34, VC36) zur Anwendung auf die Vielzahl der abstimmbaren Schaltkreise (14, 20, 22) zu erzeugen;

Mittel zur Kopplung der analogen Steuersignale (VC32, VC34, VC36) an jeweils einen der abstimmbaren Schaltkreise, **dadurch gekennzeichnet**,

dass die Schaltkreismittel (32, 34, 36) des Weiteren Mittel (50, 52, 54) zur Skalierung der Abstimmspannung (Vto) als Reaktion auf das digitale Kanalauswahlsignal zur Erzeugen der analogen Steuersignale (VC32, VC34, VC36) enthalten, wobei der Wert der Skalierung von dem digitalen Kanalauswahlsignal bestimmt wird.

**Revendications**

1. Appareil dans un système d'accord (1), ledit système d'accord comportant

un moyen d'entrée (12) pour recevoir une pluralité de signaux RF correspondant à des canaux respectifs ;
un moyen de sélection de fréquence (14, 18) pour sélectionner un de ladite pluralité de signaux RF correspondant à un canal sélectionné respectif ;
un moyen de conversion (24) pour produire au niveau d'une sortie un signal porteur d'information conformément à la modulation d'un signal RF sélectionné, ledit appareil comprenant :
une pluralité de circuits accordables (14, 20, 22) couplés entre ledit moyen d'entrée et ladite sortie et coopérant en vue de commander la caractéristique de fréquence dudit système d'accord (10) entre ladite entrée et ladite sortie

;
chacun desdits circuits accordables comportant un élément réactif ayant une valeur réactive déterminée par la grandeur de signaux de commande analogiques respectifs (VC32, VC34, VC36) ;
un moyen (40) pour fournir une pluralité de signaux de sélection de canal numériques en réponse à un canal sélectionné ;
un moyen (28) comprenant une boucle asservie en phase pour générer une tension d'accord (Vto) ayant une grandeur sensible audit canal sélectionné ;
un moyen de circuit (32, 34, 36) comprenant un moyen pour combiner ladite tension d'accord (Vto) de ladite boucle asservie en phase (28) auxdits signaux de sélection de canal numériques en vue de produire lesdits signaux de commande analogiques (VC32, VC34, VC36) destinés à être appliqués à ladite pluralité de circuits accordables (14, 20, 22) ;
un moyen pour coupler lesdits signaux de commande analogiques (VC32, VC34, VC36) à des circuits respectifs desdits circuits accordables, et caractérisé en ce que :
ledit moyen de circuit (32, 34, 36) comporte en outre un moyen (50, 52, 54) pour mettre à l'échelle ladite tension d'accord (Vto) en réponse audit signal de sélection de canal numérique en vue de produire lesdits signaux de commande analogiques (VC32, VC34, VC36), la valeur de mise à l'échelle étant déterminée par ledit signal de sélection de canal numérique.

FIGURE 1

FIGURE 2

FIGURE 3

VOLTAGE DIVIDER
54, 52 $= 1 - k_2$
$= R_{52}/(R_{54} + R_{52})$

FIGURE 4